# EUROPEAN PATENT APPLICATION

(11) **EP 0 529 998 A1**
(43) Date of publication of application: **03.03.1993**
(21) Application number: 92307730.9
(22) Date of filing: 25.08.1992
(51) Int. Cl.: G01J 5/34, H01L 37/02

(54) **Uncooled focal plane array**

(30) Priority: 26.08.1991 US 751240
(71) Applicant: TEXAS INSTRUMENTS INCORPORATED, Dallas Texas 75265 (US)
(72) Inventor: Beratan, Howard R., Richardson, Texas 75081 (US); Dudley, Dana, Dallas, Texas 75248 (US); Hanson, Charles M., Richardson, Texas 75081 (US)
(74) Representative: Blanco White, Henry Nicholas

(57) **Abstract**

A pyroelectric material (13) which operates as a capacitor and thermally driven voltage or current source and rests over a thermally insulating aerogel (5) is disposed over an integrated circuit (3) having pads or the like on the surface thereof of standard type for making connection to an external electrically conductive element. The aerogel is a highly thermally insulating, extremely low mass material on the surface of the integrated circuit with integrated circuit connection areas thereon. The preferred aerogel is a layer of glass which is from about 90 to about 99.8% porous with interconnecting porosity in the form of a rigid foam. Vias (7) are etched through the thermally insulating layer for electrical interconnection between the detector to be formed and the integrated circuit. Two contacts per pixel in the form of an electrically conductive, infrared frequency reflecting layer (11) are deposited upon the insulating layer, one such contact connected to the integrated circuit through the via and the second such contact connected to a bus or another via shared by several pixels. The pyroelectric detector material, which is sufficiently thin to permit a sufficient amount of the infrared frequency radiations impinging thereon to pass therethrough to the reflecting layer therebelow, is deposited upon and between the electrodes. The detector is preferably a ferroelectric, preferably lead lanthanum zirconate titanate. Finally, a top semi-transparent electrically conductive metal layer (15), preferably of nickel, is deposited upon the pyroelectric material.

## Description

### BACKGROUND OF THE INVENTION

### FIELD OF THE INVENTION

This invention relates to a focal plane array and, more specifically, to a thermally sensitive focal plane array which is fabricated as a monolithic structure along with associated electronic circuitry.

### BACKGROUND AND BRIEF DESCRIPTION OF THE PRIOR ART

Detectors for focal plane arrays are designed to detect electromagnetic radiations in the infrared frequency range, usually from about the 3 to 14 micron region. In the detection of such radiation, two distinct and mutually exclusive phenomena are distinguished - photon detection and thermal detection. Photon detectors change some measurable property as a result of the quantum absorption of radiation, whereas thermal detectors, the subject of the present invention, change some measurable property as a result of absorption of heat from whatever source, including radiation. In order for absorbed radiation to produce a measurable change in the temperature of the detector, the detector must be thermally isolated from its environment. The detector must further be of sufficiently low thermal mass for response to time-varying signals. Both the thermal isolation (thermal resistance, measured, for example, in degrees C./watt or degrees K/watt) and the thermal mass (heat capacity measured, for example, in Joules/degree K affect the detector responsivity beyond the physical properties of the detector material itself.

Sensors based upon high density uncooled focal plane arrays of the prior art have been range limited both by resolution (for reasonable fields of view) and by sensitivity. Prior art pyroelectric focal plane arrays are fabricated by joining a pyroelectric detector array to an integrated circuit array via thermally insulating electrically conductive bump bonds. Sensitivity is limited by insufficient thermal insulation and excessive combination of thermal mass of the detector elements. Resolution is limited by the physical integrity of detector elements that must be reticulated to reduce thermal crosstalk.

It is apparent that a reduction in the linear cell dimension with concomitant increase in the number of pixels and maintenance of the sensor noise-equivalent temperature difference (NETD) is desirable. To achieve high performance, the detector structure must be of low thermal mass and have high thermal isolation. In addition, in order to minimize manufacturing costs, a monolithic structure is preferred which would eliminate the necessity of bonding or otherwise interconnecting two or more separately manufactured devices (i.e. the detector and the electronic circuitry). The device must also be robust without unsupported or cantilevered structures in order to limit special handling requirements. It is also desirable that vacuum conditions not be required. In addition, the need for a separate optical absorption layer should be avoided to remove parasitic thermal mass and the additional processing steps required for the formation of the absorption layer.

### SUMMARY OF THE INVENTION

In accordance with the present invention, there is provided an uncooled monolithic pyroelectric, preferably ferroelectric focal plane array with associated electronic circuitry which meets all of the above noted desirable requirements which were not met by prior art focal plane array circuits.

Briefly, the focal plane array comprises a thermally responsive, preferably ferroelectric material which operates as a capacitor and rests over a highly thermally insulating layer of material which, in turn, is disposed over an integrated circuit having pads or the like on the surface thereof of standard type for making connection to an external electrically conductive element. The layer of highly thermally insulating material is of extremely low mass, in the form of an aerogel and preferably a refractory oxide aerogel, such as silicon dioxide, disposed on the surface of the integrated circuit and supporting the thermally responsive material thereon. It is desired that the aerogel have maximum thermal insulating properties.

Aerogels are well known materials and are rigid foams having interconnecting porosity, the aerogel utilized herein being, preferably, but not necessarily, a layer of silicon oxide containing material, though other materials can be used, such as, for example, vanadium pentoxide and other materials, such as oxides or organics, which is from about 90 to about 99.8% air with interconnected porosity among the pores therein, and appearing in the form of a rigid foam. The glass material forming the aerogel, when a refractory oxide is used, need not be a silicate. Also, the aerogel can be crystalline or amorphous. The aerogel as used herein must be highly thermally insulating and preferably electrically insulating, depending upon the application and/or environment. Vias are etched through the thermally insulating layer for electrical interconnection between the detector to be formed and the integrated circuit. Two contacts per pixel in the form of an electrically conductive, infrared frequency reflecting layer, such as, for example, platinum, are deposited upon the insulating layer, one such contact connected to the integrated circuit through the via and the second such contact connected to a bus or another via shared by several pixels.

The detector material, which is thermally sensitive, for example a pyroelectric, thermoelectric, ferroelectric or bolometric material, preferably but not necessarily a ferroelectric ceramic which is sufficiently thin to permit a sufficient amount of the infrared frequency radiations impinging thereon to pass therethrough to the reflecting layer therebelow, is deposited upon and between the electrodes. The detector preferably has a high pyroelectric coefficient and electrical resistivity, low dielectric loss, and dielectric constant chosen so that the capacitance of the pixel will be comparable to or larger than that of the electronics, preferably lead lanthanum zirconate titanate. Finally, a top semi-transparent electrically conductive layer, preferably of nickel/chromium, is deposited upon the pyroelectric material. The thermal isolation (aerogel) material could also act as the detector if it has the required thermal sensing capability, such as, for example, a change of resistance with temperature change, vanadium pentoxide being such a material, such devices being useful in resistive bolometers and the like.

The top layer forms an equipotential surface which effectively makes two series capacitors from each pixel. The effective capacitance is about one-fourth the value that would result if the top metal layer were one electrode and the two contacts were combined to form the other electrode. This geometry eliminates the need for over-the-edge metallization and permits a high capacitance monolithic device. By adjusting the sheet resistance of the top metal layer and the thickness of the pyroelectric material (approximately one micron), the detector itself becomes a resonant absorber.

In accordance with another embodiment of the invention, the reflecting electrodes of the prior embodiment are are decreased in size and the semi-transparent electrically conductive electrode is replaced by a dielectric layer.

Critical features of the present invention are the thermal insulation and the thin film pyroelectric material. The insulator is an aerogel film.

Three principal noise sources contribute to the net signal-to-noise ratio. These are preamplifier noise, detector noise and thermal noise. The preamplifier noise is independent of detector parameters. Detector noise results from dielectric loss within the detector material. Thermal noise results from random fluctuations of the detector temperature.

In order to overcome preamplifier noise, it is necessary not only to achieve a high degree of thermal isolation, but also to select a thin film detector material having large dE/dT, where E is the electric field and T is the temperature, a parameter characteristic of the detector material. The preferred material is lead zirconate titanate (PZT) and its solid solutions. Films of this material and related alloys have been produced to thicknesses substantially less than one micron while maintaining bulk properties.

### BRIEF DESCRIPTION OF THE DRAWINGS

Figure 1 is a cross-sectional view of a portion of an array in accordance with the present invention;
Figure 2 is a top, partially cut away, view of the array of Figure 1; and
Figure 3 is a cross-sectional view of a third embodiment of the present invention.

### DESCRIPTION OF THE PREFERRED EMBODIMENT

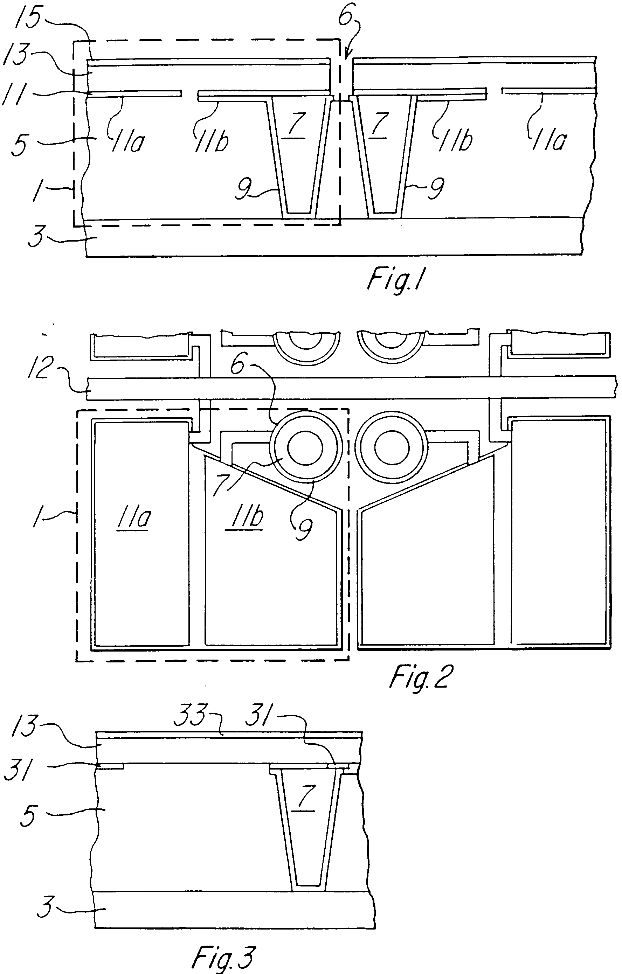

Referring to FIGURES 1 and 2, there is shown a schematic diagram of a pair of pixels 1 of a focal plane array in accordance with the present invention, it being understood that the entire array comprises many pixels arranged in a matrix formation. The pixel 1 includes an integrated circuit 3 having pads (not shown) or the like on a surface thereof, the fabrication steps thereof being standard to the point of fabrication as shown. A layer of material which is a good thermal insulator and can provide such thermal insulation with relatively low mass (from about 1 to about 100 micrometers and preferably about 10 micrometers in thickness), preferably a silicate aerogel 5 is disposed over the integrated circuit 3 to provide thermal isolation between the integrated circuit and the detector array to be formed thereover. Vias 7 are then formed in the aerogel layer 5 and electrically conductive material 9 is formed in the via extending to a pad or other connection area on the integrated circuit 3 as well as to the top of the aerogel layer. An electrically conducting and infrared frequency reflecting layer 11 in the form of an electrode, preferably of nickel, chromium or nichrome, is then formed over the insulating layer 5, the reflecting layer 11 being coupled to the electrically conductive material 9 disposed in the vias 7 and extending to a connection area or pad on the integrated circuit 3.

A layer of detecting material 13, preferably of lead lanthanum zirconate titanate, is then formed over the reflecting layer 11 and a semi-transparent electrically conductive electrode 15, preferably of thin nickel, chromium or nichrome is deposited over the detecting layer. The reflecting layer 11 can be in two unconnected portions 11a and 11b as shown in FIGURE 1 for each pixel, thereby eliminating the requirement of a connection to the electrode 15. Electrode 15 acts as an equipotential plane connecting layers 11a and 11b to each other as series capacitors. The thick bus 12 (FIGURE 2) is a common voltage line used to bias the pixel. There is one such bus 12 per pixel row. The rectangle 11a and trapezoid 11b shown in FIGURE 2 form a portion of a complete pixel - they are the shape of the backside infrared reflecting electrode. The shape is chosen to fill the area efficiently. Layer 15 is unconnected. There is only a via connection to the integrated circuit from layer 11b. Layer 11a is connected to the common thick bus line 12 that supplies the voltage needed to bias the pixel. The pixels 1 are separated from each other by an etched region 6 which provides electrical as well as thermal isolation between adjacent pixels.

To form the array of FIGURES 1 and 2, the integrated circuit chip 3 is initially fabricated in standard manner to provide electronic circuitry therein with connection areas or pads on the surface thereof. The layer of aerogel 5 is then formed over the surface of the chip 3 preferably by hypercritical drying of a silicate gel film, and vias 7 are then cut through the layer 5 to the connection areas on the integrated circuit or chip 3 using standard plasma processing. Electrical conductors 9 are then formed in the vias 7 extending to the connection areas or pads on the chip 3 and to the upper edge of the vias by standard photolithograhpy and thin film metallization. The electrically conductive infrared frequency reflecting layer 11 in the form of unconnected sections 11a and 11b is then formed over the aerogel 5 by standard photolithography and thin film metallization and the sections 11b are coupled to the conductors 9. The detecting layer 13 is then formed over the reflecting layer 9 by spinning or spraying on sol-gel, laser ablation, sputtering or metalorganic chemical vapor deposition (MOCVD) techniques and the electrically conducting semitransparent layer 15 is then formed over the ceramic layer. The PZT can be patterned by plasma techniques, chemical etching, or photo-assisted etching.

In a further embodiment of the detector (not shown), the electrode 11 can be provided as a single conductor with elements 11a and 11b as shown in FIGURE 1 being connected together as a single element connected only to the via. The conductor 15 would be connected to the bus 12.

With reference to FIGURE 3, the elements 11a and 11b of FIGURE 1 are replaced by narrow electrically conductive elements 31 which have a large dimension going into the page. Also, the conductor 15 of FIGURE 1 is replaced by a dielectric layer 33 chosen to enhance IR absorption properties, such as, for example, silicon dioxide. An optional semi-transparent electrically conductive layer (not shown) can be formed over the dielectric layer 33 to further enhance IR absorption. The capacitor is now formed by the two conductive elements 31 and relies upon field fringing to define the capacitance of the element.

It can be seen that there has been provided an uncooled focal plane array and integrated circuit which is fabricated as a monolithic device with the desired advantages as enumerated hereinabove.

Though the invention has been described with respect to a specific preferred embodiment thereof, many variations and modifications will immediately become apparent to those skilled in the art. It is therefore the intention that the appended claims be interpreted as broadly as possible in view of the prior art to include all such variations and modifications.

The "split" (light reflecting layer having a pair of unconnected portions) reflecting backside electrodes provides electrical contact from the IC to the pixels in conjunction with an equipotential semi-transparent electrical conductor on the pixel surface. This can tune the pixel so that it becomes a resonant cavity IR absorber. Pixel and read out IC interconnection is simplified by eliminating the need for over the edge metallization while providing a means to completely reticulate the pixel array and maintain high pixel capacitance.

## Claims

1. A monolithic thermally sensitive array and integrated circuit comprising: (a) a semiconductor chip (3) having electronic circuitry disposed therein and electrical connection areas thereon; (b) a thermally sensitive array (11, 13, 15) disposed over said semiconductor chip; (c) an aerogel (5) having vias (7) extending therethrough disposed between said chip and said array, insulating said chip from said array; and (d) an electrical interconnect (9) extending along said vias coupling said electrical connection areas on said chip to said array; (e) said thermally sensitive array including a plurality of pixels (1), each pixel (1) including a light reflecting layer having a pair regions electrically insulated from each other (11a, 11b) disposed over said aerogel and coupled to said electrical interconnect, a layer of detecting material (13) disposed over said light reflecting layer and a semitransparent electrically conductive layer (15) disposed over said layer of detecting material forming a pair of series capacitors with said electrically insulated portions of said light reflecting layer.

2. The device of claim 1 wherein said light reflecting layer is composed of one of nickel, chromium and nichrone.

3. The device of claim 1 or claim 2 wherein said detecting material is lead lanthanum zirconate titanate.

4. The device of any of claims 1 to 3 wherein said semi-transparent electrically conductive layer is composed of one of nickel, chromium and nichrome.

5. A device as set forth in any one of claims 1 to 4, wherein said aerogel is composed of an oxide material.

6. A device as set forth in any one of claims 1 to 4, wherein said aerogel is composed of glass.

7. A device as set forth in any one of claims 1 to 4, wherein said aerogel is composed of a silicate.

8. A device as set forth in claim 1 to 7, wherein said aerogel is from about 90 to about 99.8 percent by volume porous.

9. A device as claimed in any preceding claim and wherein said array is a focal plane array.

10. A device as claimed in claim 9 wherein said array includes:
(a) an infrared frequency reflecting electrode disposed over said aerogel;
(b) a layer of thermally sensitive material disposed over said reflecting electrode; and
(c) a semi-transparent electrically conducting layer disposed over said thermally sensitive;
(d) said electrical interconnect extending to said reflecting electrode.

11. A device as claimed in claim 9 said array including:
a layer of thermally sensitive material disposed over said aerogel;
a pair of spaced electrical conductors disposed between said thermally sensitive layer and said aerogel; and
a dielectric layer disposed over said thermally sensitive layer;
said electrical interconnect extending to said spaced electrical conductors.

12. A device as claimed in claim 10 or claim 11 and wherein said thermally sensitive material is a ceramic.

13. A device as claimed in any of claims 10 to 12 and wherein said thermally sensitive material is a pyroelectric.

14. A device as set forth in any of claims 10 to 12 and wherein said thermally sensitive material is a ferroelectric.

15. A device as set forth in claim 14 wherein said ferroelectric is taken from the class consisting of lead zirconium titanate and alloys thereof.

16. A device as set forth in claim 11 or any of claims 12 to 15 in that they depend from claim 11 further including a semi-transparent electrically conductive layer disposed over said dielectric layer.
